# EUROPEAN PATENT APPLICATION

(11) **EP 4 772 669 A1**
(43) Date of publication of application: **08.07.2026**
(21) Application number: 24859617.3
(22) Date of filing: 22.08.2024
(51) Int. Cl.: C23C 16/18, C07F 7/08, C07F 7/10, C07F 9/94, C07F 19/00, C23C 16/455

(54) **METHOD FOR PRODUCING THIN FILM AND RAW MATERIAL FOR FORMING THIN FILM**

(30) Priority: 28.08.2023 JP 2023137946
(71) Applicant: ADEKA CORPORATION, Arakawa-ku Tokyo 116-8554 (JP)
(72) Inventor: OOE, Yoshiki, Tokyo 116-8554 (JP); MITSUI, Chiaki, Tokyo 116-8554 (JP)
(74) Representative: Müller-Boré & Partner Patentanwälte PartG mbB
(86) International application number: PCT/JP2024/029883
(87) International publication number: WO 2025/047584

(57) **Abstract**

The present invention provides: a method of producing a thin-film, including forming a bismuth metal thin-film by using a bismuth compound represented by the following general formula (1) and at least one kind selected from Bi(SiMe₃)₃ and a reducing gas; and to a thin-film forming raw material: 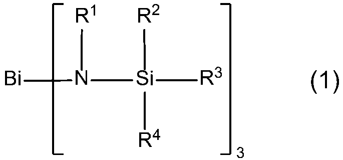 in the general formula (1), R¹ represents a hydrogen atom or a hydrocarbon group having 1 or more and 5 or less carbon atoms, and R², R³, and R⁴ each independently represent an alkyl group having 1 or more and 3 or less carbon atoms.

## Description

### Technical Field

The present invention relates to a method of producing a thin-film and to a thin-film forming raw material.

### Background Art

A thin-film containing a Group V element such as bismuth is used for various semiconductor devices, and an atomic layer deposition method has been known as a method of producing such thin-film.

For example, Patent Document 1 discloses the use of a thin-film of bismuth single layer for a layer of a phase change memory unit having a three-layer structure. In addition, Patent Document 2 discloses a thin-film containing bismuth, such as a bismuth strontium tantalate thin-film or a bismuth lanthanum titanate thin-film, as a thin-film of a multi-element alloy. Patent Document 3 discloses a method of producing a bismuth-containing oxide thin-film using an organic bismuth compound. Patent Document 4 lists a compound, such as Bi[N(SiMe)₂]₃ or Bi [N (Me) (SiMe₃)]₃, as an example of a metal-metalloid amide.

### Citation List

### Patent Document

[Patent Document 1] JP 2013-236079 A
[Patent Document 2] JP 2006-225381 A
[Patent Document 3] JP 2005-135914 A
[Patent Document 4] WO 2002/027063 A2

### Summary of Invention

### Technical Problem

However, it has been difficult to form a high-purity bismuth metal thin-film with a small residual carbon content by the related-art method.

Patent Document 1 discloses a method of producing a thin-film of a metal silicate, a metal phosphate, or an oxide, but there is no disclosure of a method of producing a bismuth metal thin-film.

Each of Patent Document 2, Patent Document 3, and Patent Document 4, does not disclose a method of producing a bismuth metal thin-film containing only bismuth as a metal.

Further, there has been a problem in that although bismuth exhibits good reactivity with a dissimilar metal compound, bismuth has low reactivity with a similar metal compound, and a method of producing a thin-film, which is capable of forming a high-purity bismuth metal thin-film with a high film formation rate, a uniform film thickness, and a small residual carbon content, has not been known.

Accordingly, an object of the present invention is to provide: a method of producing a thin-film, which is capable of forming a high-purity bismuth metal thin-film with a high film formation rate, a uniform film thickness, and a small residual carbon content; and a thin-film forming raw material, which is used in the method of producing a thin-film.

### Solution to Problem

The inventors of the present invention have made extensive investigations to solve the above-mentioned problems, and as a result, have found that a method of producing a thin-film by using a specific compound as a thin-film forming raw material can solve the above-mentioned problems. Thus, the inventors have completed the present invention.

That is, this disclosure provides a method of producing a thin-film, including forming a bismuth metal thin-film by using: a bismuth compound represented by the following general formula (1); and at least one kind selected from Bi(SiMe₃)₃ and a reducing gas. "Me" in the "Bi(SiMe₃)₃" represents a methyl group.

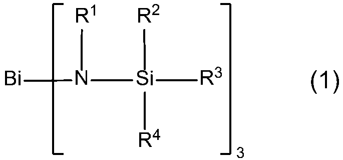

R¹ represents a hydrogen atom or a hydrocarbon group having 1 or more and 5 or less carbon atoms, and R², R³, and R⁴ each independently represent an alkyl group having 1 or more and 3 or less carbon atoms.

This disclosure provides a thin-film forming raw material set, including: a first thin-film forming raw material containing a bismuth compound represented by the following general formula (1); and a second thin-film forming raw material containing Bi(SiMe₃)₃.

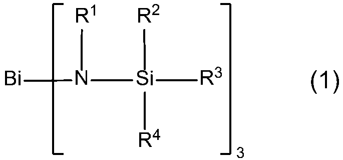

In the general formula (1), R¹ represents a hydrogen atom or a hydrocarbon group having 1 or more and 5 or less carbon atoms, and R², R³, and R⁴ each independently represent an alkyl group having 1 or more and 3 or less carbon atoms.

### Advantageous Effects of Invention

This disclosure provides: the method of producing a thin-film, which is capable of forming a high-purity bismuth metal thin-film with a high film formation rate, a uniform film thickness, and a small residual carbon content; and the thin-film forming raw material, which is used in the method of producing a thin-film.

### Brief Description of Drawings

FIG. 1 is a schematic diagram for illustrating an example of an ALD apparatus to be used in a method of producing a thin-film according to the present invention.
FIG. 2 is a schematic diagram for illustrating another example of the ALD apparatus to be used in the method of producing a thin-film according to the present invention.
FIG. 3 is a schematic diagram for illustrating still another example of the ALD apparatus to be used in the method of producing a thin-film according to the present invention.
FIG. 4 is a schematic diagram for illustrating yet still another example of the ALD apparatus to be used in the method of producing a thin-film according to the present invention.

### Description of Embodiments

A method of producing a thin-film of this disclosure is described below. First, a thin-film forming raw material used in the method of producing a thin-film of this disclosure is described.

### A. Thin-film Forming Raw Material

A thin-film forming raw material set is used as the above-mentioned thin-film forming raw material. The set includes: a first thin-film forming raw material containing a bismuth compound represented by the general formula (1) as a precursor; and a second thin-film forming raw material containing Bi(SiMe₃)₃ as a precursor.

Respective components for forming the above-mentioned first thin-film forming raw material and second thin-film forming raw material are described.

### A1. First Thin-film Forming Raw Material

In this disclosure, the first thin-film forming raw material contains the bismuth compound represented by the general formula (1) as a precursor. In the general formula (1), R¹ represents a hydrogen atom or a hydrocarbon group having 1 or more and 5 or less carbon atoms, and R², R³, and R⁴ each independently represent an alkyl group having 1 or more and 3 or less carbon atoms.

Examples of the hydrocarbon group having 1 or more and 5 or less carbon atoms that is represented by R¹ in the general formula (1) include an alkyl group having 1 or more and 5 or less carbon atoms, an alkenyl group having 2 or more and 5 or less carbon atoms, and an alkynyl group having 2 or more and 5 or less carbon atoms.

Examples of the alkyl group having 1 or more and 5 or less carbon atoms include a methyl group, an ethyl group, a n-propyl group, an isopropyl group, a n-butyl group, an isobutyl group, a sec-butyl group, a tert-butyl group, a n-pentyl group (n-amyl group), an isopentyl group (isoamyl group), a sec-pentyl group (sec-amyl group), a tert-pentyl group (tert-amyl group), and a neopentyl group.

The alkenyl group having 2 or more and 5 or less carbon atoms refers to a group in which two hydrogen atoms are removed from the alkyl group, and examples thereof include a vinyl group, a propenyl group, a butenyl group, and a pentenyl group.

The alkynyl group having 2 or more and 5 or less carbon atoms refers to a group in which two hydrogen atoms are removed from the carbon atom having the unsaturated bond of the alkenyl group, and examples thereof include an ethynyl group, a propynyl group, a butynyl group, and a pentynyl group.

Examples of the alkyl group having 1 or more and 3 or less carbon atoms that is represented by each of R², R³, and R⁴ in the general formula (1) include alkyl groups each having a predetermined number of carbon atoms out of alkyl groups each having 1 or more and 5 or less carbon atoms that are each represented by R¹.

In this disclosure, from the viewpoint of easily forming a high-purity bismuth metal thin-film with a high film formation rate, a uniform film thickness, and a small residual carbon content, R¹ represents preferably a hydrogen atom or an alkyl group having 1 or more and 3 or less carbon atoms, more preferably a hydrogen atom, a methyl group, or a n-propyl group, even more preferably a methyl group or a n-propyl group.

In this disclosure, from the viewpoint of easily forming a high-purity bismuth metal thin-film with a high film formation rate, a uniform film thickness, and a small residual carbon content, R², R³, and R⁴ each represent more preferably a methyl group or an ethyl group, even more preferably a methyl group.

Preferred specific examples of the bismuth compound represented by the general formula (1) include Compounds No. 1 to No. 75 below. However, the present invention is not limited to those compounds. In the following chemical formulae, "Me" represents a methyl group, "Et" represents an ethyl group, "nPr" represents a n-propyl group, "iPr" represents an isopropyl group, "nBu" represents a n-butyl group, "iBu" represents an isobutyl group, "sBu" represents a sec-butyl group, "tBu" represents a tert-butyl group, "n-Amyl" represents an n-amyl group, "i-Amyl" represents an isoamyl group, "s-Amyl" represents a sec-amyl group, "t-Amyl" represents a tert-amyl group, and "Np" represents a neopentyl group.

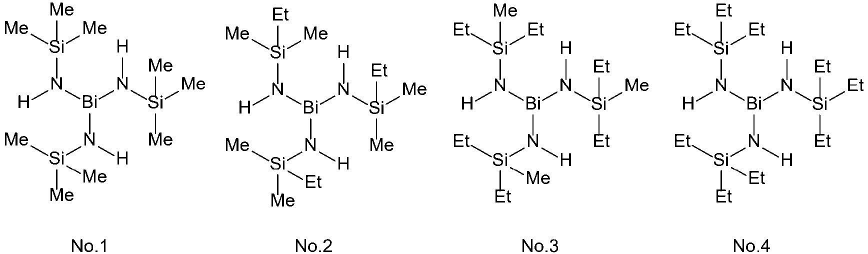

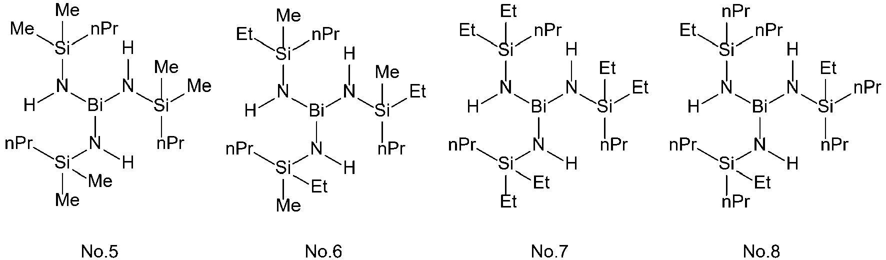

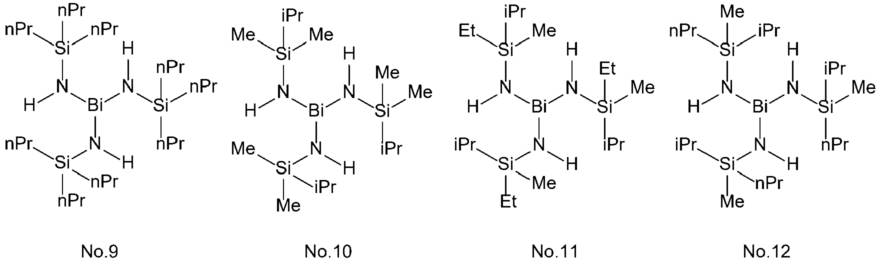

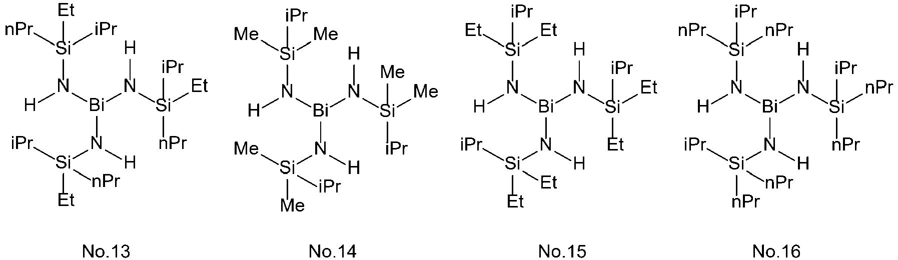

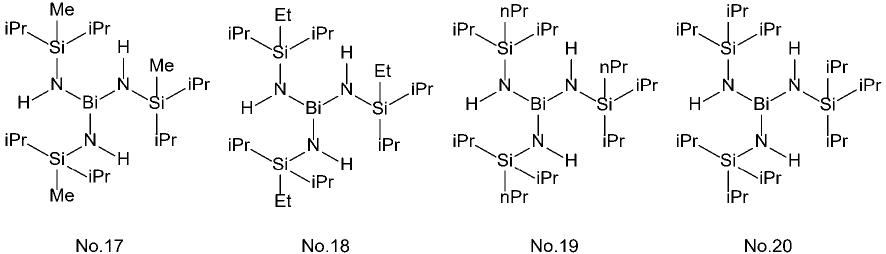

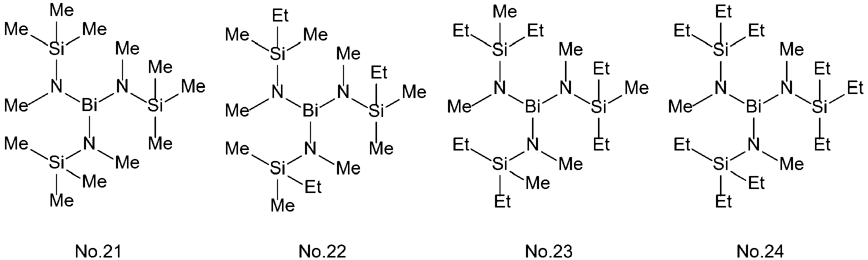

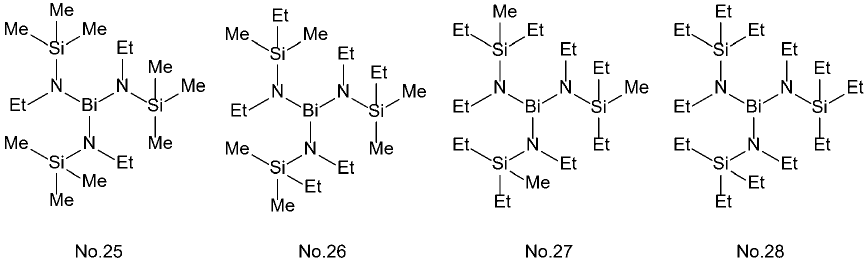

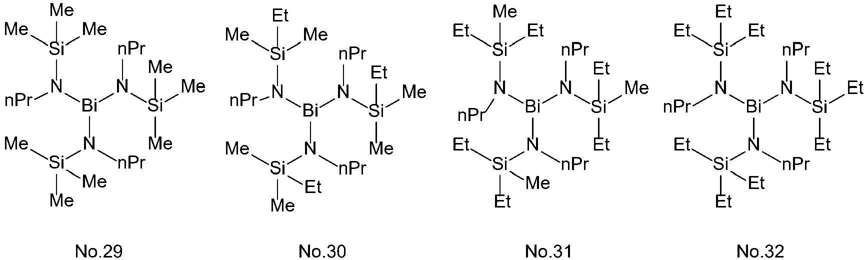

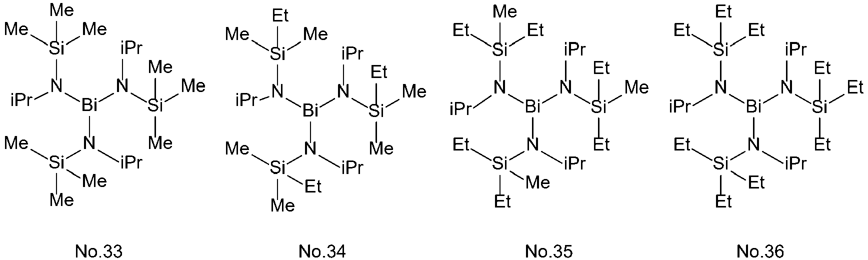

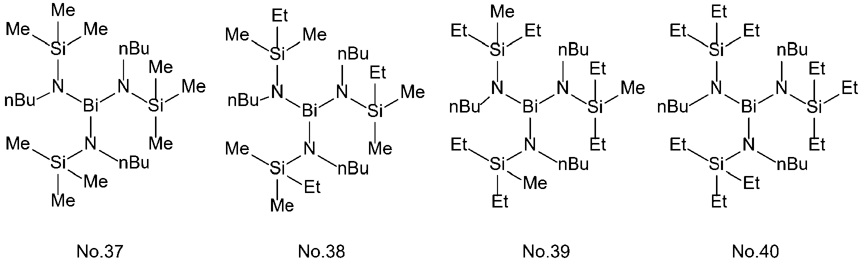

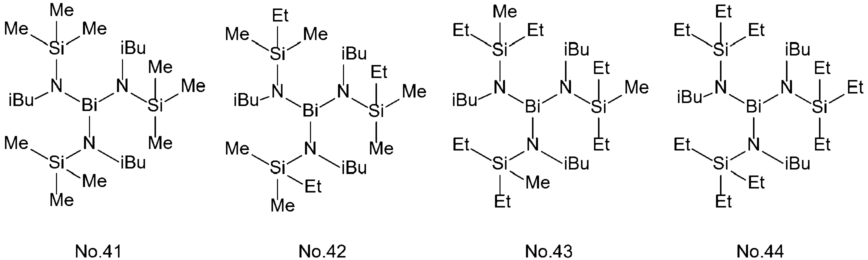

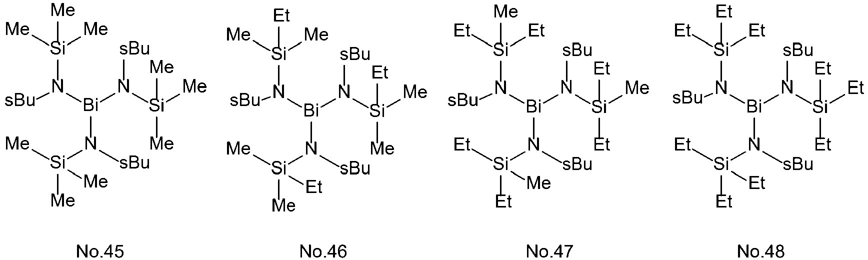

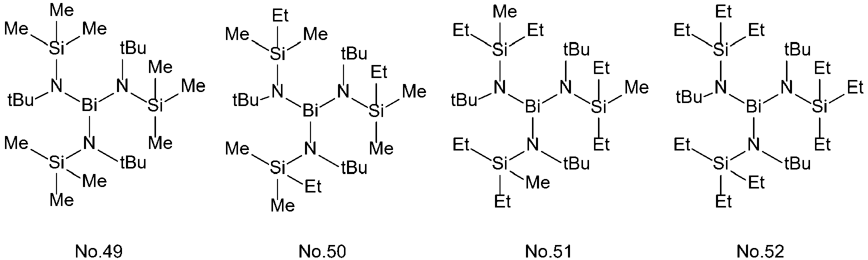

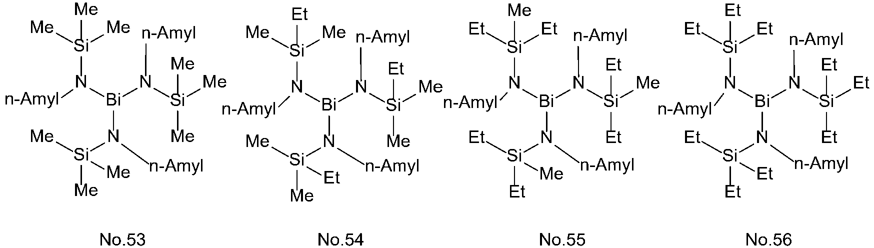

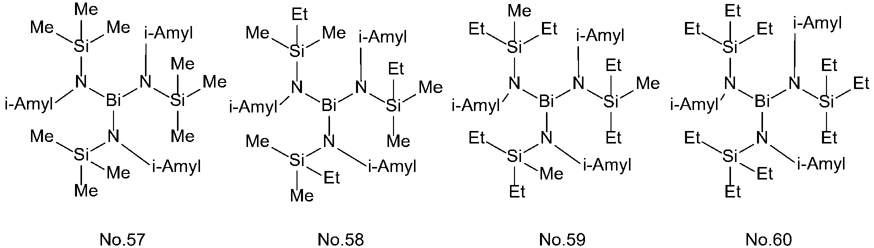

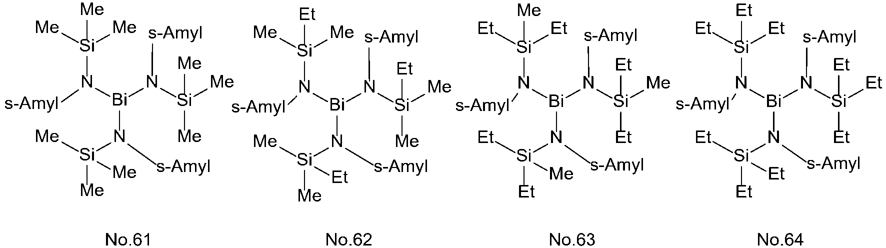

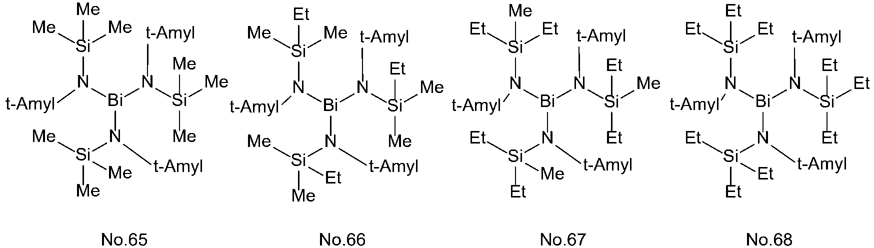

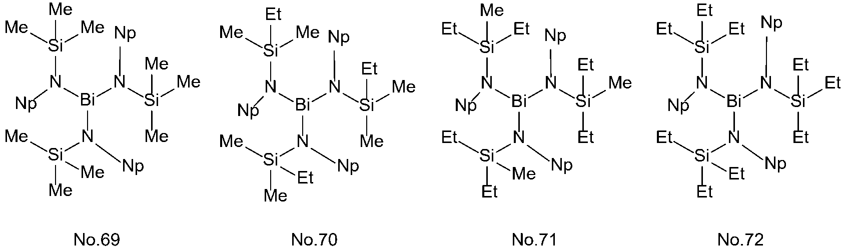

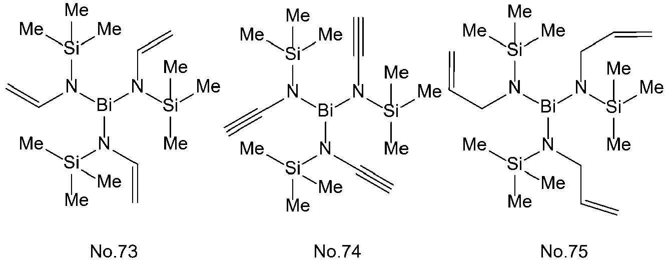

In this disclosure, from the viewpoint of easily forming a high-purity bismuth metal thin-film with a high film formation rate, a uniform film thickness, and a small residual carbon content, the first thin-film forming raw material preferably includes Compound No. 1, Compound No. 21, Compound No. 25, and Compound No. 29, more preferably employs Compound No. 21, Compound No. 25, or Compound No. 29, and even more preferably employs Compound No. 21 and Compound No. 29.

In this disclosure, from the viewpoint of easily forming a high-purity bismuth metal thin-film with a high film formation rate, a uniform film thickness, and a small residual carbon content, for example, the molecular weight of the bismuth compound represented by the general formula (1) is preferably 400 or more and 1,000 or less, more preferably 450 or more and 750 or less, even more preferably 480 or more and 650 or less, most preferably 500 or more and 600 or less.

### A2. Second Thin-film Forming Raw Material

In this disclosure, the second thin-film forming raw material contains Bi(SiMe₃)₃ as a precursor.

### A3. Other Components

The first thin-film forming raw material and second thin-film forming raw material only need to contain the bismuth compound represented by the general formula (1) and Bi(SiMe₃)₃, respectively, and the composition of each of the thin-film forming raw materials varies depending on the kind of a thin-film to be formed. For example, the thin-film forming raw materials may each contain another component as required. Examples of the other component include another precursor and a nucleophilic reagent described later.

### (1) Other Precursor

The above-mentioned other precursor may be a compound different from the bismuth compound represented by the general formula (1) and Bi(SiMe₃)₃. From the viewpoint that a single bismuth metal thin-film is formed, a metal atom for forming the other precursor is preferably the same bismuth atom as those of the bismuth compound represented by the general formula (1) and Bi(SiMe₃)₃.

The first and second thin-film forming raw materials may each contain, as the other precursor, a well-known general precursor. Examples of the other precursor include compounds of: one kind or two or more kinds selected from compounds used as organic ligands, such as an alcohol compound, a glycol compound, a β-diketone compound, a cyclopentadiene compound, and an organic amine compound; and a bismuth atom.

Examples of the alcohol compound to be used as the organic ligand in the other precursor include: alkyl alcohols, such as methanol, ethanol, propanol, isopropyl alcohol, butanol, sec-butyl alcohol, isobutyl alcohol, tert-butyl alcohol, pentyl alcohol, isopentyl alcohol, and tert-pentyl alcohol; ether alcohols, such as 2-methoxyethanol, 2-ethoxyethanol, 2-butoxyethanol, 2-(2-methoxyethoxy)ethanol, 2-methoxy-1-methylethanol, 2-methoxy-1,1-dimethylethanol, 2-ethoxy-1,1-dimethylethanol, 2-isopropoxy-1,1-dimethylethanol, 2-butoxy-1,1-dimethylethanol, 2-(2-methoxyethoxy)-1,1-dimethylethanol, 2-propoxy-1,1-diethylethanol, 2-sec-butoxy-1,1-diethylethanol, and 3-methoxy-1,1-dimethylpropanol; and dialkylamino alcohols, such as dimethylaminoethanol, ethylmethylaminoethanol, diethylaminoethanol, dimethylamino-2-pentanol, ethylmethylamino-2-pentanol, dimethylamino-2-methyl-2-pentanol, ethylmethylamino-2-methyl-2-pentanol, and diethylamino-2-methyl-2-pentanol.

Examples of the glycol compound to be used as the organic ligand in the other precursor include 1,2-ethanediol, 1,2-propanediol, 1,3-propanediol, 2,4-hexanediol, 2,2-dimethyl-1,3-propanediol, 2,2-diethyl-1,3-propanediol, 1,3-butanediol, 2,4-butanediol, 2,2-diethyl-1,3-butanediol, 2-ethyl-2-butyl-1,3-propanediol, 2,4-pentanediol, 2-methyl-1,3-propanediol, 2-methyl-2,4-pentanediol, 2,4-hexanediol, and 2,4-dimethyl-2,4-pentanediol.

Examples of the β-diketone compound to be used as the organic ligand in the other precursor include: alkylsubstituted β-diketones, such as acetylacetone, hexane-2,4-dione, 5-methylhexane-2,4-dione, heptane-2,4-dione, 2-methylheptane-3,5-dione, 5-methylheptane-2,4-dione, 6-methylheptane-2,4-dione, 2,2-dimethylheptane-3,5-dione, 2,6-dimethylheptane-3,5-dione, 2,2,6-trimethylheptane-3,5-dione, 2,2,6,6-tetramethylheptane-3,5-dione, octane-2,4-dione, 2,2,6-trimethyloctane-3,5-dione, 2,6-dimethyloctane-3,5-dione, 2,9-dimethylnonane-4,6-dione, 2-methyl-6-ethyldecane-3,5-dione, and 2,2-dimethyl-6-ethyldecane-3,5-dione; fluorine-substituted alkyl β-diketones, such as 1,1,1-trifluoropentane-2,4-dione, 1,1,1-trifluoro-5,5-dimethylhexane-2,4-dione, 1,1,1,5,5,5-hexafluoropentane-2,4-dione, and 1,3-diperfluorohexylpropane-1,3-dione; and ether-substituted β-diketones, such as 1,1,5,5-tetramethyl-1-methoxyhexane-2,4-dione, 2,2,6,6-tetramethyl-1-methoxyheptane-3,5-dione, and 2,2,6,6-tetramethyl-1-(2-methoxyethoxy)heptane-3,5-dione.

Examples of the cyclopentadiene compound to be used as the organic ligand in the other precursor include cyclopentadiene, methylcyclopentadiene, ethylcyclopentadiene, propylcyclopentadiene, isopropylcyclopentadiene, butylcyclopentadiene, sec-butylcyclopentadiene, isobutylcyclopentadiene, tert-butylcyclopentadiene, dimethylcyclopentadiene, tetramethylcyclopentadiene, and pentamethylcyclopentadiene.

Examples of the organic amine compound to be used as the organic ligand in the other precursor include methylamine, ethylamine, propylamine, isopropylamine, butylamine, sec-butylamine, tert-butylamine, isobutylamine, dimethylamine, diethylamine, dipropylamine, diisopropylamine, ethylmethylamine, propylmethylamine, and isopropylmethylamine.

The other precursor is known in the art, and a production method therefor is also known. As an example of the production method, when the alcohol compound is used as the organic ligand, for example, the other precursor may be produced through a reaction between an inorganic salt of a bismuth atom or a hydrate of the inorganic salt, and an alkali metal alkoxide of the alcohol compound.

In this case, examples of the inorganic salt of the bismuth atom may include a halide and a nitrate of a bismuth atom.

Examples of the alkali metal alkoxide may include a sodium alkoxide, a lithium alkoxide, and a potassium alkoxide.

In the method of producing a thin-film of this disclosure, when the other precursor is used as the thin-film forming raw material, the other precursor is preferably a compound that exhibits thermal decomposition and/or oxidative decomposition behavior similar to those of the bismuth compound represented by the general formula (1) or Bi(SiMe₃)₃ from the viewpoint of easily forming a high-purity bismuth metal thin-film with a high film formation rate, a uniform film thickness, and a small residual carbon content.

In the method of producing a thin-film of this disclosure, when a mixture obtained by mixing the bismuth compound represented by the general formula (1) or Bi(SiMe₃)₃ and the other precursor is used as the thin-film forming raw material, the other precursor is preferably a compound that exhibits thermal decomposition and/or oxidative decomposition behavior similar to those of the bismuth compound represented by the general formula (1) or Bi(SiMe₃)₃, and that does not undergo a change through a chemical reaction or the like after being mixed with the bismuth compound represented by the general formula (1) or Bi(SiMe₃)₃ from the viewpoint of easily forming a high-purity bismuth metal thin-film with a high film formation rate, a uniform film thickness, and a small residual carbon content.

In the method of producing a thin-film of this disclosure, when the other precursor is incorporated into the thin-film forming raw material, from the viewpoint of easily forming a high-purity bismuth metal thin-film with a high film formation rate, a uniform film thickness, and a small residual carbon content, the content of the other precursor is preferably 50 parts by mass or less, more preferably 30 parts by mass or less, even more preferably 10 parts by mass or less, yet even more preferably 5 parts by mass or less, most preferably 0 parts by mass (i.e., the thin-film forming raw material contains no other precursor) in 100 parts by mass of the thin-film forming raw material.

### (2) Nucleophilic Reagent

In the method of producing a thin-film of this disclosure, a nucleophilic reagent may be incorporated into each of the first and second thin-film forming raw materials in order to promote a reaction between the bismuth compound represented by the general formula (1), Bi(SiMe₃)₃, or the other precursor, and a reducing gas.

Examples of the nucleophilic reagent include: ethylene glycol ethers, such as glyme, diglyme, triglyme, and tetraglyme; crown ethers, such as 18-crown-6, dicyclohexyl-18-crown-6, 24-crown-8, dicyclohexyl-24-crown-8, and dibenzo-24-crown-8; polyamines, such as ethylenediamine, N,N'-tetramethylethylenediamine, diethylenetriamine, triethylenetetramine, tetraethylenepentamine, pentaethylenehexamine, 1,1,4,7,7-pentamethyldiethylenetriamine, 1,1,4,7,10,10-hexamethyltriethylenetetramine, and triethoxytriethyleneamine; cyclic polyamines, such as cyclam and cyclen; heterocyclic compounds, such as pyridine, pyrrolidine, piperidine, morpholine, N-methylpyrrolidine, N-methylpiperidine, N-methylmorpholine, tetrahydrofuran, tetrahydropyran, 1,4-dioxane, oxazole, thiazole, and oxathiolane; β-keto esters, such as methyl acetoacetate, ethyl acetoacetate, and 2-methoxyethyl acetoacetate; and β-diketones, such as acetylacetone, 2,4-hexanedione, 2,4-heptanedione, 3,5-heptanedione, and dipivaloylmethane.

When the first and second thin-film forming raw materials each contain the nucleophilic reagent, the content of the nucleophilic reagent falls within the range of preferably from 0.1 mol or more to 10 mol or less, more preferably from 1 mol or more to 4 mol and less with respect to 1 mol of the total amount of precursors from the viewpoint of easily controlling the reaction between the bismuth compound represented by the general formula (1), Bi(SiMe₃)₃, or the other precursor, and the reducing gas to be described later.

The above-mentioned total amount of precursors herein refers the total amount of the precursors included in the first thin-film forming raw material and the second thin-film forming raw material, and represents the total amount of the bismuth compound represented by the general formula (1), Bi(SiMe₃)₃, and the other precursor.

When the first thin-film forming raw material and second thin-film forming raw material are each free of the other precursor, the total amount of precursors refers to the amount of the bismuth compound represented by the general formula (1) and the bismuth compound represented by Bi(SiMe₃)₃.

### (3) Impurities

It is desired that the thin-film forming raw material be prevented from including impurities, such as impurity metal elements, impurity halogens, and impurity organic substances, to the extent possible, except for the above-mentioned constituents, that is, the bismuth compound represented by the general formula (1), Bi(SiMe₃)₃, the other precursor, and the nucleophilic reagent for forming the thin-film forming raw material.

Examples of the impurity metal elements include metal elements different from the bismuth metal of each of the bismuth compound represented by the general formula (1) and Bi(SiMe₃)₃. The content of each of the impurity metal elements in the first thin-film forming raw material or second thin-film forming raw material is preferably 100 ppm or less, more preferably 10 ppm or less, even more preferably 1 ppm or less in terms of elemental content.

The content of each of the impurity halogens in the first and second thin-film forming raw materials is preferably 100 ppm or less, more preferably 10 ppm or less, even more preferably 1 ppm or less.

Examples of the impurity organic substances may include organic substances different from the organic substances for forming the bismuth compound represented by the general formula (1), Bi(SiMe₃)₃, and the other precursor. The organic substances are compounds each containing carbon and oxygen (excluding carbon monoxide and carbon dioxide), and examples thereof include organic compounds other than the bismuth compound represented by the general formula (1), Bi(SiMe₃)₃, and the other precursor.

The content of each of the impurity organic substances in the first and second thin-film forming raw materials is preferably 500 ppm or less, more preferably 50 ppm or less, even more preferably 10 ppm or less in terms of total content.

In addition, moisture causes generation of particles in the first and second thin-film forming raw materials, and generation of particles during thin-film formation, and hence it is preferred to remove moisture from each of the bismuth compound represented by the general formula (1), Bi(SiMe₃)₃, the other precursor, and the nucleophilic reagent in advance at the time of use in order to reduce moisture therein. The moisture content of each of the bismuth compound represented by the general formula (1), Bi(SiMe₃)₃, the other precursor, and the nucleophilic reagent is preferably 10 ppm or less, more preferably 1 ppm or less.

In addition, it is preferred that the first and second thin-film forming raw materials be each prevented from including particles to the extent possible in order to reduce or prevent particle contamination of a thin-film to be formed. Specifically, in particle measurement with a light scattering liquid particle detector in a liquid phase, it is preferred that the number of particles larger than 0.3 µm be 100 or less in 1 ml of the liquid phase, and it is more preferred that the number of particles larger than 0.2 µm be 100 or less in 1 ml of the liquid phase.

The physical properties of the bismuth compound represented by the general formula (1) or Bi(SiMe₃)₃ are also suitable for CVD methods, and hence the above-mentioned thin-film forming raw materials are useful as chemical vapor deposition raw materials. Of those, the first thin-film forming raw material is particularly suitable for ALD methods because the bismuth compound represented by the general formula (1) has a wide ALD window. Accordingly, the first thin-film forming raw material is particularly useful as a thin-film forming raw material for an ALD method.

The set of the first and second thin-film forming raw materials of this disclosure can form a bismuth metal thin-film excellent in electrical characteristics and optical characteristics. For example, those thin-films are useful as an electrode and a contact layer for various semiconductor devices. The set of the thin-film forming raw materials of this disclosure is particularly useful as a thin-film forming raw material for forming a bismuth metal thin-film.

### B. Method of producing Thin-Film

Next, a method of producing a thin-film of this disclosure is described.

This disclosure provides a method of producing a thin-film, including forming a bismuth metal thin-film by using a bismuth compound represented by the general formula (1), Bi(SiMe₃)₃, or a reducing gas.

In particular, the method of producing a thin-film of this disclosure preferably involves producing a thin-film by an ALD method.

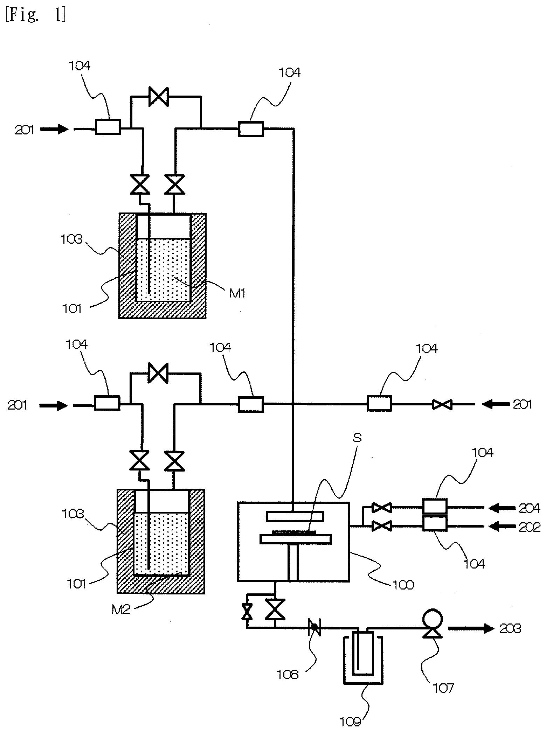

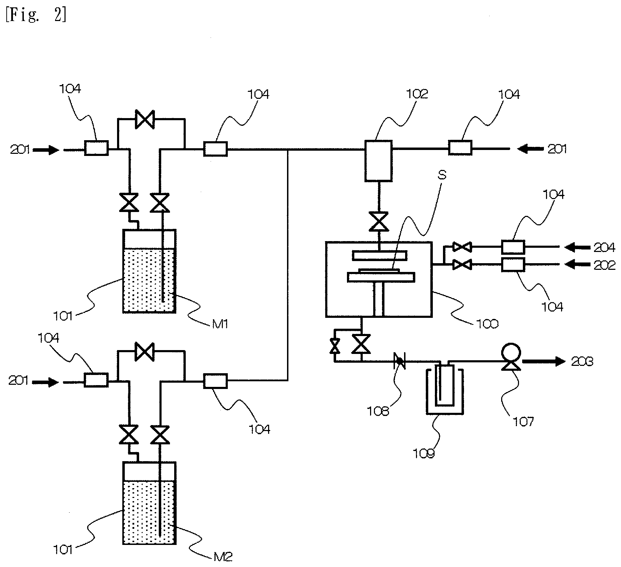

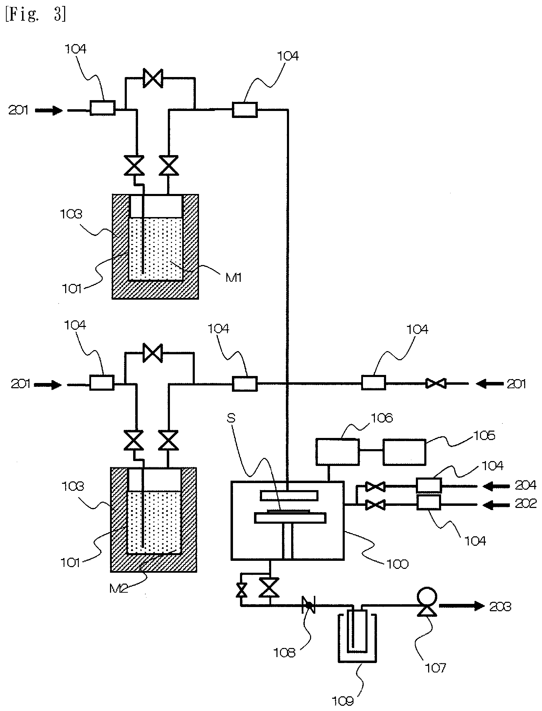

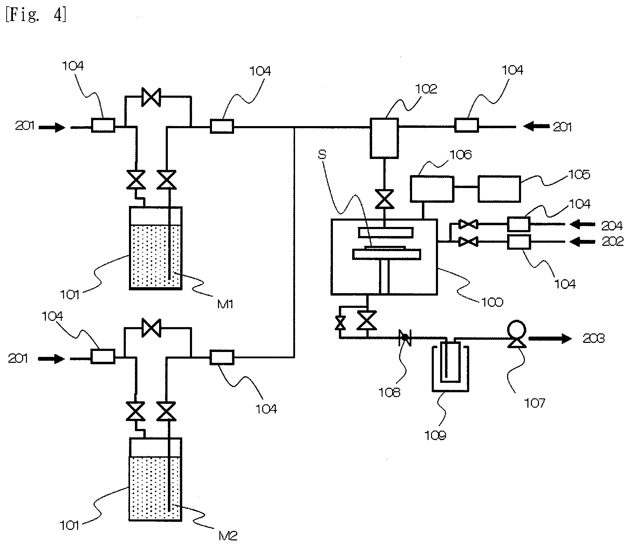

A well-known ALD apparatus may be used as an apparatus used for the method of producing a thin-film of this disclosure. Specific examples of the apparatus include: such an apparatus capable of performing bubbling supply of a precursor as illustrated in each of FIG. 1 and FIG. 3; and such an apparatus including a vaporization chamber 102 as illustrated in each of FIG. 2 and FIG. 4. Another specific example thereof is such an apparatus capable of performing plasma treatment in a film formation chamber 100 as illustrated in each of FIG. 3 and FIG. 4. The apparatus is not limited to such single-substrate type apparatus each including the film formation chamber 100 as illustrated in FIG. 1 to FIG. 4, and an apparatus capable of simultaneously processing a large number of substrates through use of a batch furnace may also be used. Those apparatus may also be used as CVD apparatus.

For example, the method of producing a thin-film by an ALD method of this disclosure includes: a step of introducing, into a film formation chamber, a first raw material gas obtained by vaporizing a first thin-film forming raw material including the bismuth compound represented by the general formula (1), and depositing, onto a surface of a substrate, the bismuth compound represented by the general formula (1) in the first raw material gas to form a precursor thin-film; and a bismuth metal thin-film formation step of introducing, into the film formation chamber, a second raw material gas obtained by vaporizing a second thin-film forming raw material including Bi(SiMe₃)₃ or a reducing gas, and causing the precursor thin-film and the second raw material gas or the reducing gas to react with each other to form a bismuth metal thin-film.

In addition, when the second thin-film forming raw material is used in the bismuth metal thin-film formation step, the method may include as required, after the bismuth metal thin-film formation step, a step of introducing a reducing gas into the film formation chamber, and causing the bismuth metal thin-film and the reducing gas to react with each other to highly purify the bismuth metal thin-film.

Each step in the method of producing a thin-film by an ALD method of this disclosure is described below with reference to FIG. 1 to FIG. 4.

### B1. Precursor Thin-film Formation Step

In this step, a first raw material gas obtained by vaporizing a first thin-film forming raw material M1 including the bismuth compound represented by the general formula (1) is introduced into the film formation chamber 100, and the bismuth compound in the first raw material gas is deposited onto a surface of a substrate S to form a precursor thin-film.

### (1) Substrate

The substrate S is not particularly limited as long as the substrate S can support the precursor thin-film. The substrate S only needs to be a known substrate, and may include an organic compound or an inorganic compound, for example.

Examples of a material for the substrate S include: silicon; ceramics, such as silicon nitride, titanium nitride, tantalum nitride, titanium oxide, molybdenum oxide, zirconium oxide, hafnium oxide, and lanthanum oxide; glass; and metals, such as metal cobalt, metal molybdenum, molybdenum sulfide, molybdenum selenide, tungsten sulfide, and tungsten selenide. The shape of the substrate is, for example, a plate shape, a spherical shape, a fibrous shape, a scaly shape, a plate shape, such as a flat plate or a disc shape, a fibrous shape, a columnar shape, a prismatic shape, a cylindrical shape, a helical shape, a spherical shape, a ring shape, or a three-dimensional structure such as a trench structure.

The thickness of the substrate S is not particularly limited in this disclosure, but is, for example, preferably 1 Å or more and 1 µm or less, preferably 1 Å or more and 50 nm or less from the viewpoint of easily forming a high-purity bismuth metal thin-film with a high film formation rate, a uniform film thickness, and a small residual carbon content.

The surface of the substrate S includes not only a surface of the substrate S such as silicon, but also a surface of the bismuth metal thin-film formed through cycles of the method of producing a thin-film to be described later.

### (2) Introduction of First Raw Material Gas

In the method of producing a thin-film of this disclosure, the first raw material gas is obtained by vaporizing the first thin-film forming raw material M1 including the bismuth compound represented by the general formula (1).

As a method of obtaining the first raw material gas, there is given, for example, a method including heating and/or decompressing the first thin-film forming raw material M1 including the bismuth compound represented by the general formula (1).

As a method of heating the first thin-film forming raw material M1, there are given, for example, a method including heating the thin-film forming raw material with a heater 103 or the like in a raw material container 101 in an ALD apparatus illustrated in FIG. 1 or FIG. 3, and a method including heating the thin-film forming raw material in the vaporization chamber 102 in an ALD apparatus illustrated in FIG. 2 or FIG. 4.

The temperature range in which the first thin-film forming raw material M1 is heated is, for example, preferably 300°C or less, more preferably the range of from 20°C or more to 250°C or less, even more preferably the range of from 30°C or more to 200°C or less from the viewpoint of easily forming a high-purity bismuth metal thin-film with a high film formation rate, a uniform film thickness, and a small residual carbon content.

As a method of decompressing the first thin-film forming raw material M1, there is given, for example, a method including decompressing the thin-film forming raw material in the raw material container 101 of the ALD apparatus illustrated in FIG. 1 or FIG. 3, or a method including decompressing the thin-film forming raw material in the vaporization chamber 102 of the ALD apparatus illustrated in FIG. 2 or FIG. 4.

The decompressing (degree of vacuum) condition falls within the range of, for example, preferably from 1 Pa or more to 10,000 Pa or less, more preferably from 10 Pa or more to 5,000 Pa or less, even more preferably from 20 Pa or more to 1,000 Pa or less from the viewpoint of easily forming a high-purity bismuth metal thin-film with a high film formation rate, a uniform film thickness, and a small residual carbon content.

As a method of introducing the first raw material gas into the film formation chamber 100, there are given, for example, a gas transportation method and a liquid transportation method.

An example of the gas transportation method is such a method as illustrated in each of FIG. 1 and FIG. 3 including heating and/or vaporizing the first thin-film forming raw material M1 in the raw material container 101 to provide the first raw material gas, and introducing the first raw material gas into the film formation chamber 100 together with a carrier gas 201, such as argon, nitrogen, or helium, as required.

An example of the liquid transportation method is such a method as illustrated in each of FIG. 2 and FIG. 4 including transporting the first thin-film forming raw material M1 to the vaporization chamber 102 under a state of a liquid or a solution, heating and/or decompressing the first thin-film forming raw material M1 in the vaporization chamber 102 to provide the first raw material gas, and introducing the first raw material gas into the film formation chamber 100 together with the carrier gas 201, such as argon, nitrogen, or helium, as required. The flow rate of each gas is adjusted by a mass flow controller (MFC) 104.

When the first thin-film forming raw material M1 contains the other precursor, the first raw material gas may be introduced into the film formation chamber 100 by using a single source method, for example.

### (3) Formation of Precursor Thin-film

In the precursor thin-film formation step, as described above, the bismuth compound in the first raw material gas introduced into the film formation chamber 100 is deposited onto the surface of the substrate S placed in the film formation chamber 100 in advance to form the precursor thin-film. The term "deposition" in this disclosure represents a concept encompassing a state in which a compound is chemically adsorbed onto the surface of the substrate S. The term "bismuth compound" represents a precursor containing a bismuth atom in the first thin-film forming raw material M1 or a second thin-film forming raw material M2.

In this step, it is preferred that any one of the inside of the film formation chamber 100 and the substrate S be heated. From the viewpoint of easily forming a high-purity bismuth metal thin-film with a high film formation rate, a uniform film thickness, and a small residual carbon content, the first raw material gas is heated at a temperature in the range of, for example, preferably from 25°C or more to 270°C or less, more preferably from 25°C or more to 250°C or less, even more preferably from 25°C or more to 230°C or less.

In this step, from the viewpoint of easily forming a high-purity bismuth metal thin-film with a high film formation rate, a uniform film thickness, and a small residual carbon content, the first raw material gas is preferably heated under a non-oxidizing atmosphere. In particular, the gas is more preferably heated under an inert gas atmosphere, such as a nitrogen gas or an argon gas, and is even more preferably heated under an inert gas atmosphere.

In addition, the heating reaction may be performed under any of the following conditions: under increased pressure, under reduced pressure, under normal pressure, and under atmospheric pressure. In this step, however, the heating reaction is preferably performed under reduced pressure (20 Pa or more and 1,000 Pa or less).

This is because a high-purity bismuth metal thin-film with a high film formation rate, a uniform film thickness, and a small residual carbon content can be formed.

### B2. Bismuth Metal Thin-film Formation Step

In this step, the second raw material gas obtained by vaporizing the second thin-film forming raw material M2 containing Bi(SiMe₃)₃ or a reducing gas 202 is introduced into the film formation chamber 100, and the precursor thin-film, and the bismuth compound in the second raw material gas or the reducing gas 202 are caused to react with each other to form a bismuth metal thin-film.

### (1-1) Introduction of Second Raw Material Gas

In the method of producing a thin-film of this disclosure, the second raw material gas is obtained by vaporizing the second thin-film forming raw material M2 including Bi(SiMe₃)₃.

As a method of obtaining the second raw material gas, the contents of the section "B1. (2) Introduction of First Raw Material Gas" may be applied by replacing the bismuth compound represented by the general formula (1) with Bi(SiMe₃)₃, and hence the description thereof is omitted here.

However, Bi(SiMe₃)₃ may react and decompose when Bi(SiMe₃)₃ is brought into contact with the bismuth compound represented by the general formula (1). Thus, it is preferred that the first thin-film forming raw material M1 containing the bismuth compound represented by the general formula (1) be prevented from being brought into direct contact with the second thin-film forming raw material M2 containing Bi(SiMe₃)₃ by, for example, separately providing supply lines for the thin-film forming raw materials from the raw material container 101 to the film formation chamber 100 so that Bi(SiMe₃)₃ and the bismuth compound represented by the general formula (1) may not be simultaneously supplied to the film formation chamber 100 in the ALD apparatus illustrated in each of FIG. 1 to FIG. 4.

### (1-2) Formation of Bismuth Metal Thin-Film

In this step, as described above, the second raw material gas introduced into the film formation chamber 100 and the precursor thin-film are caused to react with each other to form a bismuth metal thin-film.

The same conditions as those for the heating of the first raw material gas in the section "B1 (3) Formation of Precursor Thin-film" described above may be applied to the heating of the second raw material gas and the pressure inside the film formation chamber 100 during the heating herein.

In this step, the reaction between the bismuth compound represented by the general formula (1) in the precursor thin-film and Bi(SiMe₃)₃ in the second raw material gas is promoted by heating the second raw material gas, and the bismuth metal thin-film is formed on the substrate S.

For example, as the reaction in the bismuth metal thin-film formation step when Bi[N(Me)(SiMe₃)]₃ (Compound No. 21) is used as the bismuth compound represented by the general formula (1), and Bi(SiMe₃)₃ is used, the following chemical reaction is caused, and the bismuth metal thin-film is formed on the substrate S.

Bi[N(Me)SiMe₃]₃ + Bi(SiMe₃)₃ → 2Bi (metal) + 3[Me₃Si-N(Me)(SiMe₃)

In this embodiment, an example in which the first raw material gas is first introduced into the film formation chamber 100 to form the precursor thin-film, and the second raw material gas is then introduced has been described. However, the step of forming the bismuth metal thin-film may be performed as described below. The second raw material gas obtained by vaporizing the second thin-film forming raw material M2 is first introduced into the film formation chamber 100. Bi(SiMe₃)₃ is deposited onto the surface of the substrate S to form the precursor thin-film. After that, the first raw material gas obtained by vaporizing the first thin-film forming raw material M1 containing the bismuth compound represented by the general formula (1) is introduced into the film formation chamber 100, and the precursor thin-film and the first raw material gas are caused to react with each other.

### (2-1) Introduction of Reducing Gas

In the method of producing a thin-film of this disclosure, the bismuth metal thin-film may be formed by using the reducing gas 202 instead of the second raw material gas obtained by vaporizing the second thin-film forming raw material M2.

In the method of producing a thin-film of this disclosure, the kind of the reducing gas 202 is not limited, but preferably contains at least one kind of gas selected from the group consisting of: H₂; NH₃; H₂ plasma; and NH₃ plasma from the viewpoint of easily forming a high-purity bismuth metal thin-film with a high film formation rate, a uniform film thickness, and a small residual carbon content.

The reducing gas 202 may be introduced into the film formation chamber 100 together with the carrier gas 201, such as argon, nitrogen, or helium, as required.

### (a) H₂

The content of impurities in the H₂ is preferably 10 ppm or less, more preferably 1 ppm or less, even more preferably 100 ppb or less.

This is because a high-purity bismuth metal thin-film with a high film formation rate, a uniform film thickness, and a small residual carbon content can be formed.

### (b) NH₃

The content of impurities in the NH₃ is preferably 10 ppm or less, more preferably 1 ppm or less, even more preferably 100 ppb or less.

This is because a high-purity bismuth metal thin-film with a high film formation rate, a uniform film thickness, and a small residual carbon content can be formed.

### (c) H₂ Plasma

The H₂ plasma refers to H₂ having H radicals. The H₂ plasma may be produced by, for example, generating plasma from H₂ by using direct current (DC), alternating current (RF), microwaves, or the like. Specifically, as illustrated in FIG. 3 and FIG. 4, a radio frequency (RF) matching system 106 connected to a RF power supply 105 may be installed in the film formation chamber 100 to generate plasma in the film formation chamber 100.

### (d) NH₃ Plasma

The NH₃ plasma refers to NH₃ having radicals. The NH₃ plasma may be produced by, for example, causing H₂ and N₂ to react directly with each other by using direct current (DC), alternating current (RF), microwaves, or the like. Specifically, as illustrated in FIG. 3 and FIG. 4, the radio frequency (RF) matching system 106 connected to the RF power supply 105 may be installed in the film formation chamber 100 to generate plasma in the film formation chamber 100.

In this step, another gas may be incorporated in addition to the reducing gas 202.

Examples of the other gas include: organic amine compounds, such as a monoalkylamine, a dialkylamine, a trialkylamine, and an alkylenediamine; nitriding gases obtained by vaporizing hydrazine and the like; sulfiding gases, such as sulfur, hydrogen sulfide, and dialkyl sulfides (e.g., dimethyl sulfide, diethyl sulfide, and diisopropyl sulfide); and inert gases, such as argon and nitrogen. Two or more kinds of gases may be mixed and used as the other gas.

In the method of producing a thin-film of this disclosure, from the viewpoint of easily forming a high-purity bismuth metal thin-film with a high film formation rate, a uniform film thickness, and a small residual carbon content, the content of the other gas is preferably 50 vol% or less, more preferably 10 vol% or less, even more preferably 5 vol% or less in the reducing gas 202.

In this step, from the viewpoint of easily forming a high-purity bismuth metal thin-film with a high film formation rate, a uniform film thickness, and a small residual carbon content, the reducing gas 202 preferably contains only a gas selected from the group consisting of: H₂; NH₃; H₂ plasma; and NH₃ plasma, more preferably uses only a gas selected from the group consisting of: H₂; and NH₃, and even more preferably uses only H₂ from the viewpoints of high reactivity and suppression of damage to a lower layer.

In this step, a method of introducing the reducing gas 202 into the film formation chamber 100 may be performed by the same method as the method of introducing the first raw material gas or the second raw material gas described above.

However, when H₂ plasma or NH₃ plasma is to be introduced, for example, a method in which plasma is generated by applying a voltage after H₂ or NH₃ is introduced into the film formation chamber 100 illustrated in FIG. 3 or FIG. 4 is given.

### (2-2) Formation of Bismuth Metal Thin-film

In the bismuth metal thin-film formation step, as described above, the reducing gas introduced into the film formation chamber 100 and the precursor thin-film may be caused to react with each other to form a bismuth metal thin-film.

The same conditions as those for the heating of the first raw material gas in the section "B1 (3) Formation of Precursor Thin-film" described above may be applied to the heating of the reducing gas and the pressure inside the film formation chamber 100 during the heating herein.

In this step, the precursor thin-film formed by introducing the first raw material gas into the film formation chamber 100 and depositing the bismuth compound in the first raw material gas onto the surface of the substrate S, and the reducing gas may be caused to react with each other to form a bismuth metal thin-film. However, from the viewpoint of easily forming a high-purity metal thin-film with a uniform film thickness and a small residual carbon content, in this step, it is preferred that the precursor thin-film formed by using the first raw material gas be caused to react with the second raw material gas, or the precursor thin-film formed by using the second raw material gas be caused to react with the first raw material gas.

### B3. Bismuth Metal Thin-film High Purification Step

In this step, the reducing gas 202 is introduced into the film formation chamber 100 and caused to react with the bismuth metal thin-film to highly purify the bismuth metal thin-film. The reducing gas 202 may be not only caused to react with the precursor thin-film formed by using the first raw material gas to form the bismuth metal thin-film, but also caused to react with the bismuth metal thin-film to be used to increase the ratio of the bismuth atoms in the metal thin-film (i.e., to highly purify the bismuth metal thin-film).

The high purification step herein refers to a step of increasing the content of the bismuth atoms to be close to 100 parts by mass in 100 parts by mass of the bismuth metal thin-film obtained in the previous step.

The same gas as the reducing gas 202 in the bismuth metal thin-film formation step may be used as the reducing gas 202 to be used in this step, and hence the description thereof is omitted here.

In this step, a method of introducing the reducing gas 202 into the film formation chamber 100 may be performed by the same method as the method of introducing the first raw material gas or the second raw material gas described above.

However, when H₂ plasma or NH₃ plasma is to be introduced, for example, a method in which plasma is generated by applying a voltage after H₂ or NH₃ is introduced into the film formation chamber 100 illustrated in FIG. 3 or FIG. 4 is given.

The reaction between the bismuth metal thin-film and the reducing gas 202 in this step is performed by heating the metal thin-film and/or the reducing gas. The heating in this step is preferably performed at the same temperature as those in the precursor formation step and the bismuth metal thin-film formation step from the viewpoint of facilitating efficient production of the metal thin-film with high purity.

From the viewpoint of easily forming a high-purity metal thin-film with a high film formation rate, a uniform film thickness, and a small residual carbon content, this step is preferably performed after the step of causing the precursor thin-film formed by using the first raw material gas to react with the second raw material gas to form a bismuth metal thin-film, or the step of causing the precursor thin-film formed by using the second raw material gas to react with the first raw material gas to form a bismuth metal thin-film.

### B4. Other Steps

The method of producing a thin-film of this disclosure may include exhaust steps 1 to 3, a plasma treatment step, an annealing treatment step, and a reflow step as other steps.

### (1) Exhaust Step 1

This step is performed after the precursor thin-film formation step, and is a step of exhausting (203), from the film formation chamber 100, an unreacted first raw material gas not involved in formation of the precursor thin-film.

In this step, it is ideal that the unreacted first raw material gas be completely exhausted from the film formation chamber 100, but it is not necessarily required that the gas be completely exhausted.

As an exhaust method, there are given, for example: a method including purging the inside of a system of the film formation chamber 100 with an inert gas (purge gas 204), such as helium, nitrogen, or argon; an exhaust method including decompressing the inside of the system while controlling the degree of decompression with a vacuum pump 107 and an automatic pressure controller 108; and a combination of these methods. The exhausted first raw material gas is liquefied in a cooling trap 109.

The degree of decompression in the case of decompressing the inside of the system falls within the range of, for example, preferably from 0.01 Pa or more to 300 Pa or less, more preferably from 0.05 Pa or more to 200 Pa or less, particularly preferably from 0.1 Pa or more to 150 Pa or less.

This is because the exhaust of the first raw material gas is sufficient, and a high-purity bismuth metal thin-film with a high film formation rate, a uniform film thickness, and a small residual carbon content can be formed.

### (2) Exhaust Step 2

This step is performed after the above-mentioned bismuth metal thin-film formation step, and is a step of exhausting (203), from the film formation chamber 100, an unreacted second raw material gas not involved in formation of the bismuth metal thin-film, and a by-product gas generated through the reaction between the precursor thin-film and the second raw material gas.

In this step, it is ideal that the unreacted second raw material gas and the by-product gas be completely exhausted from the film formation chamber 100, but it is not necessarily required that the gases be completely exhausted.

The same conditions as those in the exhaust step 1 may be applied to the exhaust method and the degree of decompression in the exhaust step 2.

### (3) Exhaust Step 3

This step is performed after the above-mentioned bismuth metal thin-film high purification step, and is a step of exhausting, from the film formation chamber 100, an unreacted reducing gas and a by-product gas generated when the metal thin-film is reduced.

In this step, it is ideal that the unreacted reducing gas 202 and the by-product gas be completely exhausted from the film formation chamber 100, but it is not necessarily required that the gases be completely exhausted.

The same conditions as those in the exhaust step 1 may be applied to the exhaust method and the degree of decompression in the exhaust step 3.

### (4) Plasma Treatment Step

The method of producing a thin-film of this disclosure may include the plasma treatment step of applying a voltage to the first raw material gas or the second raw material gas to generate plasma, in order to promote formation of the precursor thin-film and formation of the metal thin-film.

In this step, as illustrated in FIG. 3 and FIG. 4, the radio frequency (RF) matching system 106 connected to the RF power supply 105 may be installed in the film formation chamber 100 to generate plasma from the first raw material gas or the second raw material gas in the film formation chamber 100.

In this step, when the electrical power used to apply the voltage is too large, damage to the substrate S supporting the precursor thin-film or the bismuth metal thin-film increases. Thus, the electrical power used to apply the voltage falls within the range of, for example, preferably from 10 W or more to 1,500 W or less, more preferably from 30 W or more to 1,000 W or less, even more preferably from 50 W or more to 600 W or less.

### (5) Annealing Treatment Step

The annealing treatment step is performed after high purification of the bismuth metal thin-film, and may be a step of subjecting the bismuth metal thin-film to annealing treatment in order to achieve more satisfactory electrical characteristics of the bismuth metal thin-film.

In the annealing treatment step, the bismuth metal thin-film may be subjected to the annealing treatment under an inert atmosphere or a reducing atmosphere.

In this step, from the viewpoint of easily forming a high-purity bismuth metal thin-film with a high film formation rate, a uniform film thickness, and a small residual carbon content, the temperature in the annealing treatment falls within the range of preferably from 100°C or more to 270°C or less, more preferably from 150°C or more to 260°C or less, even more preferably from 200°C or more to 250°C or less.

### (6) Reflow Step

The reflow step is performed after formation of the bismuth metal thin-film, and may be a step of heating the bismuth metal thin-film for step embedding of the bismuth metal thin-film.

From the viewpoint of easily forming a high-purity metal thin-film with a high film formation rate, a uniform film thickness, and a small residual carbon content, the temperature in the reflow step falls within the range of, for example, preferably from 200°C or more to 600°C or less, more preferably from 230°C or more to 550°C or less, particularly preferably from 250°C or more to 500°C or less.

### B5. Film Formation Cycle

The method of producing a thin-film of this disclosure sequentially includes the precursor thin-film formation step, the exhaust step 1, the bismuth metal thin-film formation step, the exhaust step 2, the high purification step, and the exhaust step 3. The formation of the thin-film through the series of operations is defined as one cycle, and the cycle is repeated until a thin-film of a bismuth metal layer having a required film thickness is obtained. Thus, the thin-film of the bismuth metal layer having a desired film thickness can be produced. That is, the film thickness of the thin-film to be formed may be controlled by the number of cycles. For example, one layer of the bismuth metal thin-film may be formed by performing the cycle only once, or the bismuth metal thin-film having a desired film thickness may be produced by performing the cycle two or more times.

The film thickness of the thin-film obtained per cycle falls within the range of preferably from 0.1 Å or more to 1.0 nm or less, more preferably from 0.3 Å or more to 0.5 nm or less, particularly preferably from 0.5 Å or more to 0.1 nm or less.

This is because a bismuth metal thin-film having a uniform film thickness is easily obtained.

### B6. Method of producing Thin-film by Method other than ALD Method

In this embodiment, the method of producing the bismuth metal thin-film by the ALD method has been described. However, the method of producing a thin-film of this disclosure is not limited to the above-mentioned method, and the bismuth metal thin-film may be produced by a CVD method, for example.

When the method of producing a thin-film of this disclosure involves production of the bismuth metal thin-film by using the CVD method, the first raw material gas and the second raw material gas may be simultaneously introduced into the film formation chamber 100.

The bismuth metal thin-film produced by the method of producing a thin-film of this disclosure contains 90 parts by mass or more of bismuth atoms in 100 parts by mass of the thin-film.

In this disclosure, the content of the bismuth atoms is preferably 96 parts by mass or more, more preferably 97 parts by mass or more, even more preferably 98 parts by mass or more, yet even more preferably 99 parts by mass or more in 100 parts by mass of the thin-film.

This is because the bismuth metal thin-film exhibits excellent electrical characteristics and may be used for various semiconductor devices.

Examples of the semiconductor devices include a field-effect transistor (FET), a nanosheet transistor, a nanowire transistor, and a complementary field-effect (FET) transistor.

In this disclosure, the semiconductor device is preferably a FET having a transition metal dichalcogenide, such as MoS₂, MoSe₂, WS₂, or WSe₂, in a semiconductor layer. The thin-film forming raw material of this disclosure is preferably formed as a contact or a metal thin-film above or below a transition metal dichalcogenide semiconductor layer.

This is because the bismuth metal thin-film produced by the method of producing a thin-film of this disclosure is excellent in electrical characteristics.

In addition, the semiconductor device may further include another layer (e.g., an insulator layer, a conductor layer, a semiconductor layer, a buffer layer, or another intermediate layer).

### Examples

### [Example 1]

A bismuth metal thin-film was produced on a silicon substrate serving as the substrate S by using Compound No. 21 as the first thin-film forming raw material M1 and Bi(SiMe₃)₃ as the second thin-film forming raw material M2 with the ALD apparatus illustrated in FIG. 1 under the following conditions.

When the composition of the obtained thin-film was analyzed by using X-ray diffractometry and X-ray photoemission spectroscopy, the thin-film was a bismuth metal thin-film, and a residual carbon content was less than 1 atom% and a residual oxygen content was less than 1 atom% in the thin-film.

In addition, when the film thickness of the thin-film was measured by using X-ray reflectometry or spectroscopic ellipsometry, the thin-film formed on the substrate was a flat and smooth film having a film thickness of 500 Å, and a film thickness obtained per cycle was 0.5 Å. It can be generally said that the film formation rate is high when the film thickness obtained per cycle is 0.5 Å or more.

An apparatus manufactured by Rigaku Corporation was used for X-ray reflectometry, and an apparatus manufactured by J.A. Woollam Co., Inc. was used for spectroscopic ellipsometry.

### (Conditions)

| | |
|---|---|
| Reaction temperature (substrate temperature): | 200°C (step 1 to step 6) |
| Reducing gas: | H₂ |
| Substrate: | Silicon substrate |

### (Steps)

A series of steps including the following steps 1 to 6 was defined as one cycle, and the cycle was repeated 1,000 times.

Step 1: Vapor of the first thin-film forming raw material M1 (first raw material gas) obtained by vaporization under the conditions of a temperature for heating the raw material container 101 of 80°C and an internal pressure of the raw material container 101 of 100 Pa is introduced into the film formation chamber 100, and the bismuth compound in the first raw material gas is adsorbed onto the surface of the substrate S at a system pressure of 100 Pa for 15 seconds, to thereby form a precursor thin-film.

Step 2: The first raw material gas that has not been adsorbed is exhausted from the system through argon purging for 10 seconds.

Step 3: Vapor of the second thin-film forming raw material M2 (second raw material gas) obtained by vaporization under the conditions of a temperature for heating the raw material container 101 of 100°C and an internal pressure of the raw material container 101 of 100 Pa is introduced into the film formation chamber 100, and the precursor thin-film formed in the step 1 is caused to react with the second raw material gas at a system pressure of 100 Pa for 15 seconds to form the bismuth metal thin-film.

Step 4: The unreacted second raw material gas and a by-product gas are exhausted from the system through argon purging for 10 seconds.

Step 5: The reducing gas is introduced into the film formation chamber 100 and is caused to react with the bismuth metal thin-film formed in the step 3 at a system pressure of 100 Pa for 15 seconds to highly purify the bismuth metal thin-film.

Step 6: The unreacted reducing gas and a by-product gas are exhausted from the system through argon purging for 10 seconds.

### [Example 2]

A thin-film was produced on a silicon substrate serving the substrate S under the following conditions with the ALD apparatus illustrated in FIG. 1 by the same method as that in Example 1 except that Compound No. 29 was used as the first thin-film forming raw material M1 and NH₃ serving as a reducing gas was used instead of the second raw material gas.

When the composition of the obtained thin-film was analyzed by using X-ray diffractometry and X-ray photoemission spectroscopy, the thin-film was a bismuth metal thin-film, and a residual carbon content was less than 1 atom% and a residual oxygen content was less than 1 atom% in the thin-film.

In addition, when the film thickness of the thin-film was measured by using X-ray reflectometry or spectroscopic ellipsometry, the thin-film formed on the substrate was a flat and smooth film having a film thickness of 600 Å, and a film thickness obtained per cycle was 0.6 Å.

### (Conditions)

| | |
|---|---|
| Reaction temperature (substrate temperature): | 200°C (step 1 to step 4) |
| Reducing gas: | NH₃ |
| Substrate: | Silicon substrate |

### (Steps)

A series of steps including the following steps 1 to 4 was defined as one cycle, and the cycle was repeated 1,000 times.

Step 1: Vapor of the first thin-film forming raw material M1 (first raw material gas) obtained by vaporization under the conditions of a temperature for heating the raw material container of 90°C and an internal pressure of the raw material container of 100 Pa is introduced into the film formation chamber 100, and the bismuth compound in the first raw material gas is adsorbed onto the surface of the substrate S at a system pressure of 100 Pa for 15 seconds, to thereby form a precursor thin-film.

Step 2: The first raw material gas that has not been adsorbed is exhausted from the system through argon purging for 10 seconds.

Step 3: The reducing gas 202 is introduced into the film formation chamber 100, and the precursor thin-film formed in the step 1 is caused to react with the reducing gas 202 at a system pressure of 100 Pa for 15 seconds to form the bismuth metal thin-film.

Step 4: The unreacted reducing gas 202 and a by-product gas are exhausted from the system through argon purging for 10 seconds.

### [Comparative Example 1]

A thin-film was produced by using tris(dimethylamino)bismuth serving as a comparative compound of the first thin-film forming raw material compound M1 with the ALD apparatus illustrated in FIG. 1 by the same method as that in Example 1 except that the temperature for heating the raw material container 101 in the step 1 was changed to 70°C.

When the composition of the obtained thin-film was analyzed by using X-ray diffractometry and X-ray photoemission spectroscopy, the thin-film was a bismuth metal thin-film, but a residual carbon content was 20 atom% and a residual oxygen content was less than 1 atom% in the thin-film.

In addition, when the film thickness of the thin-film was measured by using X-ray reflectometry or spectroscopic ellipsometry, the thin-film formed on the substrate was a film having a film thickness of 400 Å, and a film thickness obtained per cycle was 0.4 Å.

### [Comparative Example 2]

A thin-film was produced by using tris(dimethylamino)bismuth serving as a comparative compound M1 of the first thin-film forming raw material compound with the ALD apparatus illustrated in FIG. 1 by the same method as that in Example 2 except that the temperature for heating the raw material container 101 in the step 1 was changed to 70°C.

When the composition of the obtained thin-film was analyzed by using X-ray diffractometry and X-ray photoemission spectroscopy, the thin-film was a bismuth metal thin-film, but a residual carbon content was 25 atom% and a residual oxygen content was less than 1 atom% in the thin-film.

In addition, when the film thickness of the thin-film was measured by using X-ray reflectometry or spectroscopic ellipsometry, the thin-film formed on the substrate was a film having a film thickness of 400 Å, and a film thickness obtained per cycle was 0.4 Å.

Film formation results of Example 1, Example 2, Comparative Example 1, and Comparative Example 2 are shown in Table 1 below.

**Table 1**

| | First thin-film forming raw material | Second thin-film forming raw material | Reducing gas | Thin-film | Film formation rate | Residual content |
|---|---|---|---|---|---|---|
| Example 1 | No. 21 | Bi(SiMe₃)₃ | H₂ | Bismuth metal thin-film | 0.5 Å/cycle | Residual C less than 1 atom% |
| | | | | | | Residual O less than 1 atom% |
| Example 2 | No. 29 | Not used | NH₃ | Bismuth metal thin-film | 0.6 Å/cycle | Residual C less than 1 atom% |
| | | | | | | Residual O less than 1 atom% |
| Comparative Example 1 | Bi(NMe₂)₃ | Bi(SiMe₃)₃ | H₂ | Bismuth metal thin-film | 0.4 Å/cycle | Residual C 20 atom% |
| | | | | | | Residual O less than 1 atom% |
| Comparative Example 2 | Bi(NMe₂)₃ | Not used | NH₃ | Bismuth metal thin-film | 0.4 Å/cycle | Residual C 25 atom% |
| | | | | | | Residual O less than 1 atom% |

As described above, it was confirmed that a high-purity bismuth metal thin-film with a high film formation rate, a uniform film thickness, and a small residual carbon content was able to be formed by the method of producing a thin-film of the present invention. In addition, the film thickness obtained per cycle of the bismuth metal thin-film produced by the method of producing a thin-film of the present invention was significantly large, and hence it was suggested that the method of producing a thin-film of the present invention was able to achieve high productivity.

### Reference Signs List

100 film formation chamber
101 raw material container
102 vaporization chamber
103 heater
104 mass flow controller (MFC)
105 high-frequency (RF) power supply
106 RF matching system
107 vacuum pump
108 automatic pressure controller
109 cooling trap
201 carrier gas
202 reducing gas
203 exhaust
204 purge gas
M1 first thin-film forming raw material
M2 second thin-film forming raw material
S substrate

## Claims

1. A method of producing a thin-film, comprising forming a bismuth metal thin-film by using:
a bismuth compound represented by the following general formula (1); and
at least one kind selected from Bi(SiMe₃)₃ and a reducing gas: 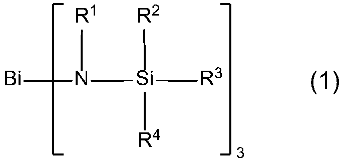
in the general formula (1), R¹ represents a hydrogen atom or a hydrocarbon group having 1 or more and 5 or less carbon atoms, and R², R³, and R⁴ each independently represent an alkyl group having 1 or more and 3 or less carbon atoms.

2. The method of producing a thin-film according to claim 1, comprising the steps of:
introducing, into a film formation chamber, a first raw material gas obtained by vaporizing a first thin-film forming raw material including the bismuth compound represented by the general formula (1), and depositing, onto a surface of a substrate, the bismuth compound in the first raw material gas to form a precursor thin-film; and
introducing, into the film formation chamber, a second raw material gas obtained by vaporizing a second thin-film forming raw material including the Bi(SiMe₃)₃, or the reducing gas, and causing the precursor thin-film and the bismuth compound in the second raw material gas or the reducing gas to react with each other to form the bismuth metal thin-film.

3. The method of producing a thin-film according to claim 1, comprising the steps of:
introducing, into a film formation chamber, a second raw material gas obtained by vaporizing a second thin-film forming raw material including the Bi(SiMe₃)₃, and depositing, onto a surface of a substrate, the bismuth compound in the second raw material gas to form a precursor thin-film; and
introducing, into the film formation chamber, a first raw material gas obtained by vaporizing a first thin-film forming raw material including the bismuth compound represented by the general formula (1), and causing the precursor thin-film and the bismuth compound in the first raw material gas to react with each other to form the bismuth metal thin-film.

4. The method of producing a thin-film according to claim 2 or 3, further comprising, after the step of forming the bismuth metal thin-film, a step of
introducing, into the film formation chamber, a reducing gas and causing the bismuth metal thin-film and the reducing gas to react with each other to highly purify the bismuth metal thin-film.

5. A thin-film forming raw material set, comprising:
a first thin-film forming raw material containing a bismuth compound represented by the following general formula (1); and
a second thin-film forming raw material containing Bi(SiMe₃)₃: 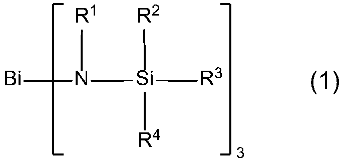
in the general formula (1), R¹ represents a hydrogen atom or a hydrocarbon group having 1 or more and 5 or less carbon atoms, and R², R³, and R⁴ each independently represent an alkyl group having 1 or more and 3 or less carbon atoms.

6. The thin-film forming raw material set according to claim 5, wherein the thin-film forming raw material set is used for forming a bismuth metal thin-film.
